(19) Europäisches Patentamt
European Patent Office
Office européen des brevets

(11) **EP 1 855 330 A1**

(12) **EUROPEAN PATENT APPLICATION**
published in accordance with Art. 158(3) EPC

(43) Date of publication:
**14.11.2007 Bulletin 2007/46**

(51) Int Cl.:
*H01L 41/09* (2006.01)   *C04B 35/49* (2006.01)
*H01L 41/187* (2006.01)   *H01L 41/22* (2006.01)
*H01L 41/24* (2006.01)

(21) Application number: **06714555.7**

(22) Date of filing: **24.02.2006**

(86) International application number:
**PCT/JP2006/303416**

(87) International publication number:
**WO 2006/093042 (08.09.2006 Gazette 2006/36)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **01.03.2005 JP 2005056222**

(71) Applicants:
• **IBIDEN CO., LTD.**
**Ogaki-shi, Gifu 503-0695 (JP)**
• **Dai Nippon Toryo Co., Ltd.**
**Osaka-City,**
**Osaka 554-0012 (JP)**

(72) Inventors:
• **ITO, Atsushi**
**ta, Ibigawa-cho, Ibi-gun, Gifu, 5010695 (JP)**

• **MATSUNO, Yoshiya**
**ta, Ibigawa-cho, Ibi-gun, Gifu, 5010695 (JP)**
• **IDO, Takahiko**
**ta, Ibigawa-cho, Ibi-gun, Gifu, 5010695 (JP)**
• **SHIKANO, Haruhide**
**ta, Ibigawa-cho, Ibi-gun, Gifu, 5010695 (JP)**
• **FUKUYASU, Shigeo**
**-chome, Konohana-ku, Osaka-shi, Osaka, 5 (JP)**
• **MATSUYAMA, Takuo**
**-chome, Konohana-ku, Osaka-shi, Osaka, 5 (JP)**

(74) Representative: **HOFFMANN EITLE**
**Patent- und Rechtsanwälte**
**Arabellastrasse 4**
**81925 München (DE)**

(54) **PIEZOELECTRIC ELEMENT**

(57)    A piezoelectric element includes an electrode disposed on at least one of the front and back surfaces of a piezoelectric material prepared by molding a mixture containing a Pb component, a Zr component, a Ti component, a Sr component, a Nb component, and a Zn component and then firing the molded product. When the piezoelectric material is represented by the general formula $Pb(Zr_aTi_{1-a})O_3 + bSrO + cNbO_{2.5} + dZnO$, the relative amounts of the respective components, for example, satisfy the relationships, $a = 0.51$, $b = 2.0 \times 10^{-2}$, **c** $= 1.50 \times 10^{-2}$, $d = 0.5 \times 10^{-2}$, and $c/d = 3.0$.

**EP 1 855 330 A1**

**Description**

Technical Field

The present invention relates to a piezoelectric element.

Background Art

Piezoelectric materials produce electric polarization when stress is applied and produce strain when an electric field is applied. The occurrence of electric polarization due to stress and the occurrence of strain due to an electric field are physical phenomena based on the same cause, and the phenomena are referred to as a "piezoelectric effect". By using the piezoelectric effect, piezoelectric elements each having electrodes disposed on the front and back surfaces of a piezoelectric material are put into practical application as a quartz oscillator, an electrometer, a sensor, a motor, an automobile part, and a wide variety of other products. A typical piezoelectric material is lead zirconate titanate (PZT) having a perovskite crystal structure, and there have been many reports of various improvements using PZT as a base.
For example, Patent Document 1 discloses $0.98Pb(Zr_{0.52}Ti_{0.48})O_3$-$0.02Sr(K_{0.25}Nb_{0.75})O_3$ as a piezoelectric material. It is also described that this piezoelectric material has a Curie temperature Tc of 347.3°C and a piezoelectric constant $d_{33}$ of 440 pm/V measured by a resonator measurement method. The Curie temperature Tc is a ferroelectric transition temperature to a paraelectric phase, and spontaneous polarization disappears at a temperature higher than the Cuie temperature Tc. Therefore, in view of the maintenance of the piezoelectric effect at a high temperature, the Curie temperature Tc is preferably as high as possible. From this viewpoint, the piezoelectric material disclosed in Patent Document 1 has excellent high temperature resistance because the Curie temperature Tc is 300°C or higher. The piezoelectric constant $d_{33}$ is an index indicating an amount of displacement when an electric field (V/m) is applied to a piezoelectric material. When a piezoelectric material is used for an actuator, the piezoelectric constant $d_{33}$ is preferably as high as possible. From this viewpoint, the piezoelectric material disclosed in Patent Document 1 is desirable because the piezoelectric constant $d_{33}$ is as relatively high as 440 pm/V. The piezoelectric constant $d_{33}$ is generally measured by a resonator measurement method. In a two-digit number attached after d, the left number denotes the electric field direction, the right number denotes the displacement direction, and the number "3" denotes the polarization direction.
Patent Document 1: Published Japanese translation of a PCT application No. 2001-515835

Disclosure of Invention

In the process of searching for materials that have characteristics superior to those of the piezoelectric material according to Patent Document 1, the present inventors have found that there are cases where the piezoelectric constant $d_{33}$ obtained by the resonator measurement method does not agree with the piezoelectric constant $d_{33}$ obtained on the basis of a displacement occurring when an electric field is actually applied to a piezoelectric material (hereinafter referred to as the "piezoelectric constant $d_{33}$ by actual displacement"), and even if the piezoelectric constant $d_{33}$ obtained by the resonator measurement is the same for piezoelectric materials, different piezoelectric constants $d_{33}$ by actual displacement are obtained. It has also been found that in known piezoelectric materials, there is a tendency in which as the Curie temperature Tc is increased, the piezoelectric constant $d_{33}$ is decreased, while as the piezoelectric constant $d_{33}$ is increased, the Curie temperature Tc is decreased. Because of the findings described above, it has been expected that there would be considerable difficulties in creating a piezoelectric material that has excellent high temperature resistance and that produces a large displacement when an electric field is applied, compared with the known piezoelectric materials.
The present invention has been achieved for solving the above-mentioned problem and provides a piezoelectric element having excellent high temperature resistance and a large actual displacement when an electric field is applied.
In order to solve the above-mentioned problem, the inventors intensively researched piezoelectric materials including lead zirconate titanate as a base. As a result, the inventors found a piezoelectric material having excellent high temperature resistance and a large actual displacement when an electric field is applied, resulting in the completion of the present invention.
A piezoelectric element according to the present invention includes an electrode disposed on at least one of the front and back surfaces of a piezoelectric material prepared by molding a mixture containing a Pb component, a Zr component, a Ti component, a Sr component, a Nb component, and a Zn component and then firing the molded product, wherein the piezoelectric material is represented by the general formula $Pb(Zr_aTi_{1-a})O_3 + bSrO + cNbO_{2.5} + dZnO$, the relative amounts of the respective components satisfying the following relations:

$$0.51 \leq a \leq 0.54;$$

$$1.1 \times 10^{-2} \leq b \leq 6.0 \times 10^{-2};$$

$$0.9 \times 10^{-2} \leq c \leq 4.25 \times 10^{-2};$$

$$0.1 \times 10^{-2} \leq d \leq 1.25 \times 10^{-2};$$

and

$$2.9 \leq c/d \leq 15.0.$$

The piezoelectric element of the present invention has not only excellent high temperature resistance but also a large actual displacement when an electric field is applied, and thus can stably exhibit the piezoelectric effect at a high temperature over a long time. Although the reason why the piezoelectric element of the present invention has the excellent functional properties is not known, the inventors suppose the following reason: As in the piezoelectric element of the present invention, when a piezoelectric material satisfying the above general formula (satisfying the numeral ranges of a to d) is used, a crystal structure is easily made asymmetric because of the strong crystal anisotropy at room temperature, and thus the material is little affected by thermal oscillation even at a high temperature and is little put into a nonpolar state. Therefore, it is thought that the material has excellent high temperature resistance. It is also thought that a crystal axis of a polycrystal is rotated by applying a voltage to produce strain, and an actual displacement is increased due to the large strain.

Brief Description of the Drawings

Fig. 1 is a circuit diagram when a piezoelectric element is used in a single layer.
Fig. 2 is a circuit diagram when a piezoelectric element is used as a multilayer piezoelectric element in which a plurality of piezoelectric elements is stacked.
Fig. 3 is a circuit diagram when a voltage is applied to a test piece of a piezoelectric element.

Best Mode for Carrying Out the Invention

In a piezoelectric element of the present invention, when a value of a is less than 0.51 or larger than 0.54, the piezoelectric constant $d_{33}$ determined from actual displacement tends to decrease. Therefore, a value of a is preferably $0.51 \leq a \leq 0.54$. A value of a is more preferably $0.53 \leq a \leq 0.54$ because a decrease in the piezoelectric constant $d_{33}$ determined from actual displacement can be suppressed even when local variation occurs in the composition.

When a value of b is less than $1.1 \times 10^{-2}$, the piezoelectric constant $d_{33}$ determined from actual displacement tends to decrease, while when a value of b is larger than $6.0 \times 10^{-2}$, the Curie temperature Tc tends to decrease. Therefore, a value of b is preferably $1.1 \times 10^{-2} \leq b \leq 6.0 \times 10^{-2}$.

When a value of c is less than $0.9 \times 10^{-2}$ or larger than $4.25 \times 10^{-2}$, the piezoelectric constant $d_{33}$ determined from actual displacement tends to decrease. Therefore, a value of c is preferably $0.9 \times 10^{-2} \leq \mathbf{c} \leq 4.25 \times 10^{-2}$.

When a value of d is less than $0.1 \times 10^{-2}$, the piezoelectric constant $d_{33}$ determined from actual displacement tends to decrease, while when a value of d is larger than $1.25 \times 10^{-2}$, the Curie temperature Tc tends to decrease. Therefore, a value of **d** is preferably $0.1 \times 10^{-2} \leq \mathbf{d} \leq 1.25 \times 10^{-2}$.

Further, even if a value of c satisfies $0.9 \times 10^{-2} \leq c \leq 4.25 \times 10^{-2}$ and a value of **d** satisfies $0.1 \times 10^{-2} \leq d \leq 1.25 \times 10^{-2}$, when a value of **c/d** is less than 2.9 or larger than 15.0, the piezoelectric constant $d_{33}$ determined from actual displacement tends to decrease. Therefore, a value of c/d is preferably $2.9 \leq c/d \leq 15.0$.

The piezoelectric element of the present invention includes an electrode disposed on at least one of the front and back surfaces of the piezoelectric material represented by the general formula $Pb(Zr_aTi_{1-a})O_3 + bSrO + cNbO_{2.5} + dZnO$ (a to d are as described above). In this case, it is preferred that (a) the piezoelectric constant $d_{33}$ determined from

a relation between voltage and displacement measured by applying a DC electric field from 0 V to 1000 V using an electric micrometer at room temperature is 900 pm/V or more (particularly 1000 pm/V or more), and the Curie temperature Tc is 300°C or higher (particularly 325°C or higher and more particularly 340°C or higher), or (b) the displacement measured by applying a DC electric field from 0 V to 200 V using an electric micrometer at room temperature is 0.18 $\mu$m or more (particularly 0.20 $\mu$m or more), and the Curie temperature Tc is 300°C or higher (particularly 325°C or higher and more particularly 340°C or higher). Since the actual displacement with the applied voltage is large, and spontaneous polarization does not disappear in use at a temperature condition lower than the Curie temperature Tc, the piezoelectric effect can be stably exhibited at a high temperature over a long period of time.

The piezoelectric element of the present invention need not necessarily include an electrode disposed on at least one of the front and back surfaces of the piezoelectric material represented by the general formula $Pb(Zr_aTi_{1-a})O_3$ + bSrO + $cNbO_{2.5}$ + dZnO (a to d are as described above). The piezoelectric element may include an electrode disposed on at least one of the front and back surfaces of a piezoelectric material containing lead zirconate titanate as a base and a Zn component. In this case, it is preferred that (a) the piezoelectric constant $d_{33}$ determined from a relation between voltage and displacement measured by applying a DC electric field from 0 V to 1000 V using an electric micrometer at room temperature is 900 pm/V or more (particularly 1000 pm/V or more), and the Curie temperature Tc is 300°C or higher (particularly 325°C or higher and more particularly 340°C or higher), or (b) the displacement measured by applying a DC electric field from 0 V to 200 V using an electric micrometer at room temperature is 0.18 $\mu$m or more (particularly 0.20 $\mu$m or more), and the Curie temperature Tc is 300°C or higher (particularly 325°C or higher and more particularly 340°C or higher). Since the actual displacement with the applied voltage is large, and spontaneous polarization does not disappear in use at a temperature condition lower than the Curie temperature Tc, the piezoelectric effect can be stably exhibited at a high temperature over a long period of time. The piezoelectric material used in the piezoelectric element preferably contains a Pb component, a Zr component, a Ti component, a Sr component, a Nb component, and Zn component.

The piezoelectric element of the present invention can be applied to various piezoelectric devices. Applicable examples of piezoelectric devices include a piezoelectric actuator, a piezoelectric buzzer, an ultrasonic cleaner, an ultrasonic motor, and an ink jet head. Since the piezoelectric element of the present invention stably exhibits the piezoelectric effect over a long time at a high temperature, the piezoelectric element is preferably used as an automobile injector, and particularly as an injector of a diesel engine common-rail system. For example, the piezoelectric element is built in near a needle in an injector so that the piezoelectric element is displaced by controlling the voltage applied to the electrode of the piezoelectric element in order to control opening and closing of a needle valve of the injector. In addition, an injector of a common rail system is required to have high responsiveness, and a type using a piezoelectric element is useful because it responds at a higher speed than the injection interval of a conventional solenoid type.

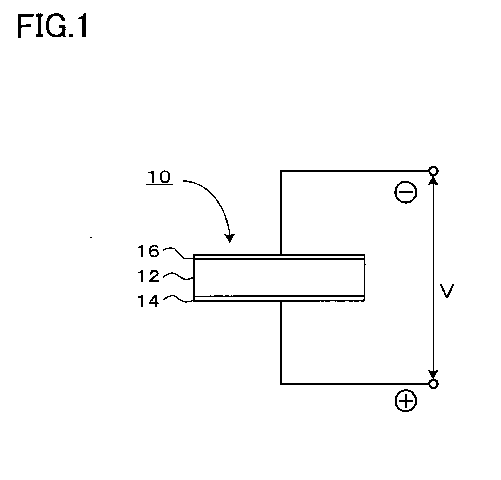

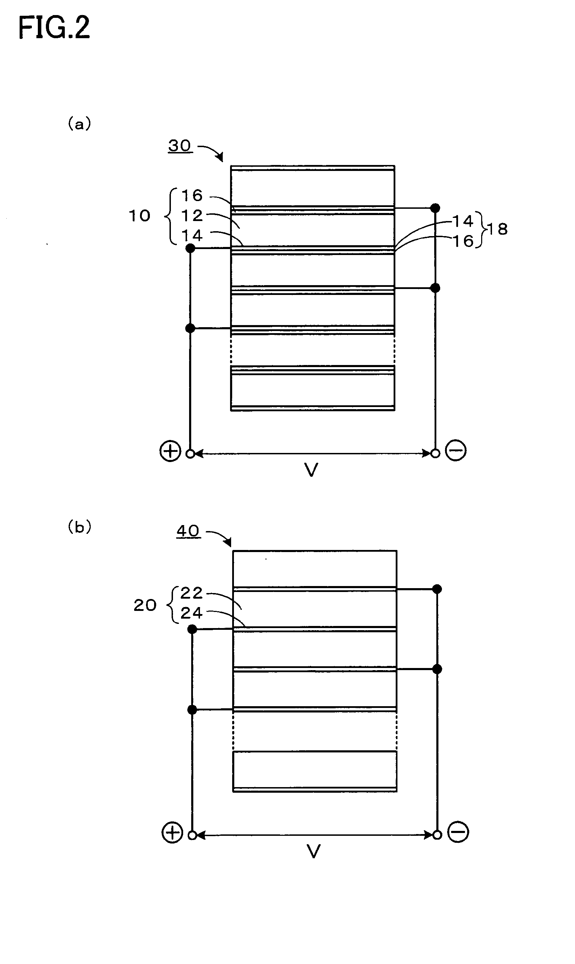

When the piezoelectric element of the present invention is used in a single layer, for example, as shown in Fig. 1, electrodes 14 and 16 are disposed on the front and back surfaces of a piezoelectric material 12 to prepare a piezoelectric element 10, and the electrode 14 is connected to a positive pole of a power supply, the other electrode 16 being connected to a negative pole of the power supply. When the piezoelectric element is used as a multilayer piezoelectric element in which a plurality of piezoelectric elements is stacked, for example, as shown in Fig. 2(a), a plurality of piezoelectric elements 10 each including electrodes 14 and 16 disposed on the front and back surfaces of a piezoelectric material 12 is stacked to prepare a multilayer piezoelectric element 30, and electrode layers 18 each including the two electrodes 14 and 16 are alternately electrically connected and connected to a positive pole of a power supply, the remaining electrode layers 18 being electrically connected and connected to a negative pole of the power supply. Alternatively, as shown in Fig. 2(b), a plurality of piezoelectric elements 20 each including an electrode 24 disposed only on the back surface of a piezoelectric material 22 is stacked to prepare a multilayer piezoelectric element 40, and the electrodes 24 are alternately electrically connected and connected to a positive pole of a power supply, the remaining electrodes 24 being electrically connected and connected to a negative pole of the power supply.

The piezoelectric element of the present invention is manufactured through, for example, (1) a raw material mixing step, (2) a mixture grinding step, (3) a calcining and grinding step, (4) a binder mixing step, (5) a granulating step, (6) a molding step, (7) a firing step, (8) a processing step, (9) an electrode forming step, and (10) a polarization step. Each of the steps will be described below.

(1) Raw material mixing step

First, necessary amounts of powders of a Pb component, a Zr component, a Ti component, a Sr component, a Nb component, and Zn component are weighed as starting materials and mixed. At this time, the types of impurities contained in the raw materials used and the particle size distributions thereof are previously determined.

The Pb component used is not particularly limited as long as the Pb component can form a lead oxide by firing, and any one of various Pb components may be used. Examples of such a Pb component include oxides such as $Pb_3O_4$ (red lead) and PbO.

The Zr component used is not particularly limited as long as the Zr component can form a zirconium oxide by firing, and any one of various Zr components may be used. Examples of such a Zr component include zirconium oxides such as zirconium dioxide, and zirconium hydroxide.

The Ti component used is not particularly limited as long as the Ti component can form a titanium oxide by firing, and any one of various Ti components may be used. Examples of such a Ti component include titanium oxides such as titanium dioxide, and titanium hydroxide.

The Sr component used is not particularly limited as long as the Sr component can form a strontium oxide by firing, and any one of various Sr components may be used. Examples of such a Sr component include strontium oxides and strontium carbonate.

The Nb component used is not particularly limited as long as the Nb component can form a niobium oxide by firing, and any one of various Nb components may be used. Examples of such a Nb component include niobium oxides such as niobium pentoxide.

The Zn component used is not particularly limited as long as the Zn component can form a zinc oxide by firing, and any one of various Zn components may be used. Examples of such a Zn component include zinc oxides, zinc nitrate, and zinc carbonate. Among these compounds, zinc oxide is preferably used in view of stabilization of the piezoelectric constant.

(2) Mixture grinding step

The raw material mixture prepared in the step (1) and pure water are added to a ball mill, and the resultant mixture is mixed and then dried. The mixing is preferably performed at a rotational speed of at least 200 rpm for a mixing time of 5 to 30 hours, and the amount of the pure water mixed is preferably 50 to 75% of the total weight. The mixture is preferably ground to become uniform over the whole. This is because when the mixture is nonuniform, reactivity in calcining and the piezoelectric characteristics of a final product are greatly affected.

(3) Calcining and grinding step

The ground mixture of the raw materials is calcined in a powder state. Before the calcining, the mixture is previously dried at, for example, 80°C to 150°C for about 1 hour in order to remove excess moisture. Then, the mixture is calcined in an oxidizing atmosphere such as air of 700°C to 1000°C (preferably 800°C to 900° C) for 1 to 7 hours. After the calcining, the powder is ground to an average particle size of 0.1 to 2.0 $\mu$m, preferably 0.1 to 1.0 $\mu$m, using a grinding apparatus such as a ball mill. In order to uniformly grind, grinding is preferably performed by a wet system using water. The grinding time is not particularly limited but is, for example, 5 to 30 hours and preferably 10 to 20 hours. After the grinding, the powder is dried to obtain a raw material powder.

(4) Binder mixing step

In order to facilitate molding, a binder may be uniformly added to the powder. As the binder used for molding, a resin, e.g., polyvinyl alcohol, can be used. The ratio by weight of the binder is preferably 0.5% or less. When the ratio by weight exceeds 0.5%, the electric properties and piezoelectricity may be degraded, and reduction of an oxide easily takes place.

(5) Granulating step

The raw material powder containing the binder is granulated. The resulting granules preferably have a grain size of 1 to 20 $\mu$m and a shape such as a circular shape, an elliptical shape, a polygonal shape, or a square shape.

(6) Molding step

The granules are molded into a desired shape. The molding may be performed by either dry molding or wet molding. Dry molding methods include a powder compression method in which granules are charged in a mold and then molded under pressure, and a hydrostatic pressing method. Wet molding methods include a doctor blade method in which a slurry or paste of raw material powder is molded into a thin plate, an extrusion molding method, and a roll molding method. Other known molding methods may be used.

(7) Firing step

The molded product is fired to form a sintered body. The firing temperature is preferably 1050°C to 1250°C, and the retention time is preferably 1 to 8 hours. In firing, the molded product may be sealed in a vessel and fired in a PbO atmosphere. Therefore, evaporation of PbO can be prevented. The temperature may be increased or decreased stepwisely until or after the firing retention time has passed. When the molded product after the molding step contains the binder, the molded product is preferably degreased and decarbonized at a temperature of 200°C to 500°C.

(8) Processing step

Polishing, cutting, surface finishing, or the like is performed so that sintered bodies have a predetermined size.

(9) Electrode baking step

Silver paste is applied to one or both surfaces of the resulting sintered body and then baked at 500°C to 800°C to form an electrode, preparing a piezoelectric element. Instead of this method, an electrode forming method including electroless plating, a vacuum evaporation method, or a sputtering method may be used. A metal other than silver, such as gold, nickel, copper, titanium, zinc, or aluminum, may be formed into a single layer or a multilayer including two or more layers. The thickness of the electrode is preferably 2 to 20 $\mu$m. When the thickness of the electrodes is less than 2 $\mu$m, an uncovered portion may locally occur in the sintered body, thereby undesirably decreasing the piezoelectric effect. When the thickness of the electrode exceeds 20 $\mu$m, the rigidity of the electrode may be increased to undesirably inhibit distortion of the piezoelectric element when a voltage is applied thereto.

(10) Polarization step

The sintered bodies are isotropic and do not exhibit piezoelectricity. Consequently, polarization treatment is performed in which a DC electric field that is larger than the intrinsic coercive electric field is applied to align the direction of spontaneous polarization. The polarization treatment is performed, for example, by immersing the workpiece in an insulating oil at about 100°C for several tens of minutes.

Examples

[Examples 1-1 to 1-4 and Comparative Examples 1-1 and 1-2]

First, PbO as a Pb component, ZrO$_2$ as a Zr component, TiO$_2$ as a Ti component, SrO as a Sr component, Nb$_2$O$_5$ as a Nb component, and ZnO as Zn component were weighed so as to satisfy each of the compositions a to d after firing in Examples 1-1 to 1-4 and Comparative Examples 1-1 and 1-2 shown in Table 1. The mixture of the components and pure water were added to a ball mill, and the resultant mixture was mixed and ground for 20 hours and then dried. The amount of the pure water added was 65% of the total weight. The rotational speed of the ball mill was 500 rpm. Then, the mixture ground with the ball mill was dehydrated by drying at 100°C for 24 hours, and then calcined in air at 850°C for 2 hours. After calcining, the powder was ground by a ball mill for 20 hours. The average particle size after grinding was 0.8 $\mu$m. Then, 0.5% by weight of polyvinyl alcohol was added as a binder to the resulting powder, and the resulting mixture was granulated to a grain size of about 1.4 $\mu$m. The granules were charged in a square mold and then molded under a pressure of 130 MPa. The molded product was fired in a Pb atmosphere to form a sintered body. In firing, the heating rate was 100 °C/hour, and the molded product was maintained for 2 hours at a temperature of 1100°C to 1200°C after the temperature was attained. The sintered body was cut into a predetermined size using a machining center and then polished for planarizing the cut sides to obtain a sintered body of 5 mm in length, 5 mm in width, and 0.5 mm in thickness. Then, the surfaces of the sintered body were polished in parallel with a horizontal plane using a high-hardness grindstone of diamond or ceramic to planarize both the front and back surfaces of the sintered body. After planarization, silver paste (manufactured by Shoei Chemical Industry Co., Ltd., part No. H5698) was printed on the sintered body and baked at 700°C for 1 hour to form electrodes on both the front and back surfaces. Then, a DC electric field of 3 kV/mm, which was higher than the coercive electric field, was applied for 2 minutes in silicone oil of 140°C to perform polarization. As a result, a piezoelectric element having electrodes on both surfaces of a piezoelectric material was obtained.
Table 1

| $Pb(Zr_a Ti_{1-a})O_3 + bSrO + cNbO_{2.5} + dZnO$ | | | | | Piezoelectric constant $d_{33}$ (pm/V) | | Actual displacement $\Delta L2(\mu m)$ | Curie temerature Tc(°C) | Rate of change in piezoelectric constant $\Delta D$(%) |
|---|---|---|---|---|---|---|---|---|---|
| | a | b | c | d | c/d | Resonation method | Actual displacement method | | | |
| Example 1-1 | 0.51 | $2.0 \times 10^{-2}$ | $1.50 \times 10^{-2}$ | $0.5 \times 10^{-2}$ | 3.0 | 400 | 1023 | 0.20 | 345 | 3.3 |
| Example 1-2 | 0.53 | $2.0 \times 10^{-2}$ | $1.50 \times 10^{-2}$ | $0.5 \times 10^{-2}$ | 3.0 | 430 | 1136 | 0.23 | 340 | 3.0 |
| Example 1-3 | 0.54 | $2.0 \times 10^{-2}$ | $1.50 \times 10^{-2}$ | $0.5 \times 10^{-2}$ | 3.0 | 400 | 1011 | 0.20 | 340 | 3.1 |
| Example 1-4 | 0.52 | $2.0 \times 10^{-2}$ | $1.50 \times 10^{-2}$ | $0.5 \times 10^{-2}$ | 3.0 | 410 | 1062 | 0.21 | 345 | 3.1 |
| Comparative Example 1-1 | 0.49 | $2.0 \times 10^{-2}$ | $1.50 \times 10^{-2}$ | $0.5 \times 10^{-2}$ | 3.0 | 380 | 651 | 0.13 | 345 | 5.9 |
| Comparative Example 1-2 | 0.55 | $2.0 \times 10^{-2}$ | $1.50 \times 10^{-2}$ | $0.5 \times 10^{-2}$ | 3.0 | 360 | 672 | 0.13 | 335 | 6.3 |

Each of the piezoelectric elements of Examples 1-1 to 1-4 and Comparative Examples 1-1 and 1-2 was measured with respect to (1) the piezoelectric constant $d_{33}$ determined by the resonation method, (2) the piezoelectric constant $d_{33}$ determined from actual displacement, (3) actual displacement $\Delta L2$, (4) the Curie temperature Tc, and (5) the rate of change in piezoelectric constant $\Delta D$ in a reliability test. Each of the measurement methods will be described.

(1) Method of measuring piezoelectric constant ($d_{33}$) by resonance method

A test piece of each of the examples and the comparative examples was measured with an impedance analyzer (manufactured by Agilent Corp., part No. 4294A) according to Electronic Materials Manufacturer's Association of Japan Standard EMA-6001 to 6006.

(2) Method of measuring piezoelectric constant (d$_{33}$) by actual displacement method

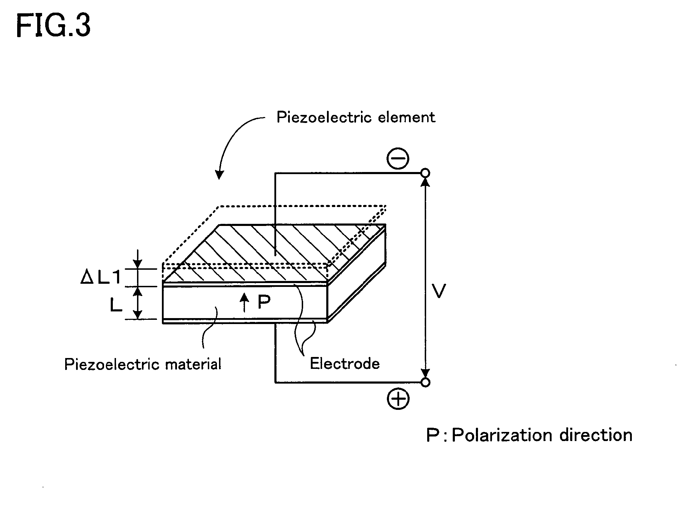

As shown in Fig. 3, a DC power supply was connected to the electrodes on both the front and back surfaces of a test piece of each of the piezoelectric elements of the examples and the comparative examples to measure actual displacement ΔL1 with an electric micrometer (manufactured by TESA Co., Ltd., part No. TT60) while applying a DC electric field of 0 to 1000 V, and d$_{33}$ was calculated by the relational expression d$_{33}$ = ΔL1/V.

(3) Method of measuring actual displacement ΔL2

A test piece of each of the examples and the comparative examples was measured with respect to actual displacement ΔL2 using an electric micrometer (manufactured by TESA Co., Ltd., part No. TT60) while applying a DC electric field of 0 to 200 V.

(4) Method of measuring Curie temperature (Tc)

A test piece of each of the examples and the comparative examples was successively heated to 200°C to 400°C to measure the temperature at which the electrostatic capacity at 1 kHz was maximized using an impedance analyzer (manufactured by Agilent Corp., part No. 4294A). The temperature at the maximum value was determined as the Curie temperature Tc.

(5) Method of calculating rate of change in piezoelectric constant ΔD in reliability test

The reliability was evaluated by a cold-hot cycle test. The piezoelectric constant (d$_{33}$0) of a test piece of each of the examples and the comparative examples was measured. Then, the test piece was subjected to 500 cycles of retention in each of which it was retained at -40°C for 30 minutes and at 280°C for 30 minutes and then allowed to stand at room temperature for 5 hours. Thereafter, the piezoelectric constant (d$_{33}$1) was again measured, and the rate of change in piezoelectric constant (ΔD) was determined by the following equation. In this method, the piezoelectric constant was determined from actual displacement.

$$\Delta D = (d_{33}0 - d_{33}1)/(d_{33}0) \times 100 \ (\%)$$

In Examples 1-1 to 1-4 and Comparative Examples 1 and 2, only the value of a was changed while the values of b, **c**, and d were fixed. As a result, as shown in Table 1, satisfactory values of the piezoelectric constant d$_{33}$, the actual displacement ΔL2, the Curie temperature Tc, and the rate of change in piezoelectric constant ΔD were obtained within the range of 0.51 ≤ a ≤ 0.54. While when the value of a was 0.49 or 0.55, the actual displacement ΔL2 was significantly decreased.

[Examples 2-1 to 2-4 and Comparative Examples 2-1 and 2-2]

Piezoelectric elements were produced by the same method as in Example 1 except that PbO, ZrO$_2$, TiO$_2$, SrO, Nb$_2$O$_5$, and ZnO were weighed so as to satisfy the compositions a to d in Examples 2-1 to 2-4 and Comparative Examples 2-1 and 2-2 shown in Table 2. Each of the piezoelectric elements was measured with respect to (1) the piezoelectric constant d$_{33}$ determined by the resonation method, (2) the piezoelectric constant d$_{33}$ determined from actual displacement, (3) actual displacement ΔL2, (4) the Curie temperature Tc, and (5) the rate of change in piezoelectric constant ΔD in a reliability test. The results are summarized in Table 2.
Table 2

| $Pb(Zr_aTi_{1-a})O_3+bSrO+cNbO_{2.5}+dZnO$ | | | | | Piezoelectric constant $d_{33}$ (pm/V) | | Actual displacement $\Delta L2(\mu m)$ | Curie temperature Tc(°C) | Rate of change in piezoelectric constant $\Delta D(\%)$ |
|---|---|---|---|---|---|---|---|---|---|
| | a | b | c | d | $c/d$ | Resonation method | Actual displacement method | | | |
| Example 2-1 | 0.53 | $1.1 \times 10^{-2}$ | $1.50 \times 10^{-2}$ | $0.5 \times 10^{-2}$ | 3.0 | 410 | 1031 | 0.21 | 345 | 3.6 |
| Example 2-2 | 0.53 | $1.2 \times 10^{-2}$ | $1.50 \times 10^{-2}$ | $0.5 \times 10^{-2}$ | 3.0 | 410 | 1058 | 0.21 | 345 | 3.3 |
| Example 2-3 | 0.53 | $5.0 \times 10^{-2}$ | $1.50 \times 10^{-2}$ | $0.5 \times 10^{-2}$ | 3.0 | 430 | 1107 | 0.22 | 310 | 3.8 |
| Example 2-4 | 0.53 | $6.0 \times 10^{-2}$ | $1.50 \times 10^{-2}$ | $0.5 \times 10^{-2}$ | 3.0 | 430 | 1121 | 0.20 | 310 | 4.4 |
| Comparative Example 2-1 | 0.53 | $1.0 \times 10^{-2}$ | $1.50 \times 10^{-2}$ | $0.5 \times 10^{-2}$ | 3.0 | 380 | 718 | 0.13 | 350 | 4.7 |
| Comparative Example 2-2 | 0.53 | $7.0 \times 10^{-2}$ | $1.50 \times 10^{-2}$ | $0.5 \times 10^{-2}$ | 3.0 | 430 | 837 | 0.13 | 290 | 85.1 |

In Examples 2-1 to 2-4 and Comparative Examples 2-1 and 2-2, only the value of b was changed while the values of a, c, and d were fixed. As a result, as shown in Table 2, satisfactory values of the piezoelectric constant $d_{33}$, the actual displacement $\Delta L2$, the Curie temperature Tc, and the rate of change in piezoelectric constant $\Delta D$ were obtained within the range of $1.1 \times 10^{-2} \leq b \leq 6.0 \times 10^{-2}$. While when the value of b was $1.0 \times 10^{-2}$ or $7.0 \times 10^{-2}$, the actual displacement $\Delta L2$ was significantly decreased. In the latter case, i.e., when the value of b was $7.0 \times 10^{-2}$, the Curie temperature Tc was lower than 300°C, and the rate of change in piezoelectric constant $\Delta D$ was greatly increased.

[Examples 3-1 to 3-6 and Comparative Examples 3-1 and 3-2]

Piezoelectric elements were produced by the same method as in Example 1 except that PbO, $ZrO_2$ $TiO_2$, SrO ,

Nb$_2$O$_5$, and ZnO were weighed so as to satisfy the compositions a to d in Examples 3-1 to 3-6 and Comparative Examples 3-1 and 3-2 shown in Table 3. Each of the piezoelectric elements was measured with respect to (1) the piezoelectric constant d$_{33}$ determined by the resonation method, (2) the piezoelectric constant d$_{33}$ determined from actual displacement, (3) actual displacement ΔL2, (4) the Curie temperature Tc, and (5) the rate of change in piezoelectric constant ΔD in a reliability test. The results are summarized in Table 3.

## Table 3

| | Pb(Zr$_a$Ti$_{1-a}$)O$_3$+bSrO+cNbO$_{2.5}$+dZnO | | | | | Piezoelectric constant d$_{33}$ (pm/V) | | Actual displacement ΔL2(μm) | Curie Temperature Tc(°C) | Rate of change in piezoelectric constant ΔD(%) |
| | a | b | c | d | c/d | Resonation method | Actual displacement method | | | |
|---|---|---|---|---|---|---|---|---|---|---|
| Example 3-1 | 0.53 | 2.0×10⁻² | 0.90×10⁻² | 0.25×10⁻² | 3.6 | 400 | 1018 | 0.20 | 350 | 3.5 |
| Example 3-2 | 0.53 | 2.0×10⁻² | 1.50×10⁻² | 0.25×10⁻² | 6.0 | 420 | 1093 | 0.22 | 345 | 3.3 |
| Example 3-3 | 0.53 | 2.0×10⁻² | 3.75×10⁻² | 0.30×10⁻² | 12.5 | 410 | 1047 | 0.21 | 320 | 3.8 |
| Example 3-4 | 0.53 | 2.0×10⁻² | 1.00×10⁻² | 0.25×10⁻² | 4.0 | 410 | 1033 | 0.21 | 345 | 3.3 |
| Example 3-5 | 0.53 | 2.0×10⁻² | 4.00×10⁻² | 0.32×10⁻² | 12.5 | 410 | 1051 | 0.21 | 310 | 3.6 |
| Example 3-6 | 0.53 | 2.0×10⁻² | 4.25×10⁻² | 0.30×10⁻² | 14.2 | 410 | 1069 | 0.21 | 300 | 3.8 |
| Comparative Example 3-1 | 0.53 | 2.0×10⁻² | 0.75×10⁻² | 0.25×10⁻² | 3.0 | 370 | 690 | 0.14 | 355 | 4.0 |
| Comparative Example 3-2 | 0.53 | 2.0×10⁻² | 4.50×10⁻² | 0.30×10⁻² | 15.0 | 410 | 821 | 0.16 | 295 | 80.6 |

In Examples 3-1 to 3-6 and Comparative Example 3-1, the values of c and d were changed while the values of a and b were fixed. As a result, as shown in Table 3, satisfactory values of the piezoelectric constant d$_{33}$, the actual

displacement ΔL2, the Curie temperature Tc, and the rate of change in piezoelectric constant ΔD were obtained within the range of $0.9 \times 10^{-2} \leq c \leq 4.25 \times 10^{-2}$. While when the value of c was $0.75 \times 10^{-2}$ or $4.50 \times 10^{-2}$, the actual displacement ΔL2 was significantly decreased. In the latter case, i.e., when the value of c was $4.50 \times 10^{-2}$, the Curie temperature Tc was lower than 300°C, and the rate of change in piezoelectric constant ΔD was greatly increased.

[Examples 4-1 to 4-9 and Comparative Examples 4-1 and 4-4]

Piezoelectric elements were produced by the same method as in Example 1 except that PbO, $ZrO_2$, $TiO_2$, SrO, $Nb_2O_5$, and ZnO were weighed so as to satisfy the compositions a to d in Examples 4-1 to 4-9 and Comparative Examples 4-1 and 4-4 shown in Table 4. Each of the piezoelectric elements was measured with respect to (1) the piezoelectric constant $d_{33}$ determined by the resonation method, (2) the piezoelectric constant $d_{33}$ determined from actual displacement, (3) actual displacement ΔL2, (4) the Curie temperature Tc, and (5) the rate of change in piezoelectric constant ΔD in a reliability test. The results are summarized in Table 4.
## Table 4

| | Pb(Zr$_a$Ti$_{1-a}$)O$_3$+bSrO+cNbO$_{2.5}$+dZnO | | | | | Piezoelectric constant d$_{33}$ (pm/V) | | Actual displacement ΔL2($\mu$m) | Curie temperature Tc(°C) | Rate of change in piezoelectric constant ΔD(%) |
|---|---|---|---|---|---|---|---|---|---|---|
| | a | b | c | d | c/d | Resonation method | Actual displacement method | | | |
| Example 4－1 | 0.53 | $2.0 \times 10^{-2}$ | $1.50 \times 10^{-2}$ | $0.52 \times 10^{-2}$ | 2.9 | 400 | 1058 | 0.21 | 345 | 3.8 |
| Example 4－2 | 0.53 | $2.0 \times 10^{-2}$ | $1.50 \times 10^{-2}$ | $0.30 \times 10^{-2}$ | 5.0 | 420 | 1091 | 0.22 | 345 | 3.6 |
| Example 4－3 | 0.53 | $2.0 \times 10^{-2}$ | $3.75 \times 10^{-2}$ | $1.00 \times 10^{-2}$ | 3.75 | 430 | 1058 | 0.21 | 305 | 3.9 |
| Example 4－4 | 0.53 | $2.0 \times 10^{-2}$ | $3.75 \times 10^{-2}$ | $0.50 \times 10^{-2}$ | 7.5 | 420 | 1086 | 0.22 | 310 | 4.6 |
| Example 4－5 | 0.53 | $2.0 \times 10^{-2}$ | $3.75 \times 10^{-2}$ | $1.25 \times 10^{-2}$ | 3.0 | 430 | 1147 | 0.23 | 300 | 4.8 |
| Example 4－6 | 0.53 | $2.0 \times 10^{-2}$ | $1.50 \times 10^{-2}$ | $0.10 \times 10^{-2}$ | 15.0 | 400 | 1030 | 0.21 | 345 | 3.2 |
| Example 4－7 | 0.53 | $2.0 \times 10^{-2}$ | $1.50 \times 10^{-2}$ | $0.20 \times 10^{-2}$ | 7.5 | 410 | 1072 | 0.21 | 340 | 3.4 |
| Example 4－8 | 0.53 | $2.0 \times 10^{-2}$ | $1.30 \times 10^{-2}$ | $0.10 \times 10^{-2}$ | 13.0 | 400 | 1053 | 0.21 | 345 | 3.7 |
| Example 4－9 | 0.53 | $2.0 \times 10^{-2}$ | $1.50 \times 10^{-2}$ | $0.10 \times 10^{-2}$ | 15.0 | 400 | 1096 | 0.22 | 345 | 3.9 |
| Comparative Example 4－1 | 0.53 | $2.0 \times 10^{-2}$ | $1.20 \times 10^{-2}$ | $0.08 \times 10^{-2}$ | 15.0 | 370 | 762 | 0.15 | 360 | 2.5 |
| Comparative Example 4－2 | 0.53 | $2.0 \times 10^{-2}$ | $1.50 \times 10^{-2}$ | $0.60 \times 10^{-2}$ | 2.5 | 300 | 633 | 0.13 | 345 | 4.8 |
| Comparative Example 4－3 | 0.53 | $2.0 \times 10^{-2}$ | $3.75 \times 10^{-2}$ | $0.20 \times 10^{-2}$ | 18.75 | 390 | 752 | 0.15 | 335 | 5.7 |
| Comparative Example 4－4 | 0.53 | $2.0 \times 10^{-2}$ | $3.75 \times 10^{-2}$ | $1.30 \times 10^{-2}$ | 2.9 | 400 | 798 | 0.16 | 295 | 82.5 |

In Examples 4-1 to 4-9 and Comparative Examples 4-1 to 4-4, the values of o and d were changed while the values of a and b were fixed. As a result, as shown in Table 4, satisfactory values of the piezoelectric constant $d_{33}$, the actual displacement $\Delta L2$, the Curie temperature Tc, and the rate of change in piezoelectric constant $\Delta D$ were obtained within the range of $0.10 \times 10^{-2} \leq d \leq 1.25 \times 10^{-2}$ and the range of $2.9 \leq c/d \leq 15.0$. While when the value of d was 0.08 $\times 10^{-2}$ or $1.30 \times 10^{-2}$, the actual displacement $\Delta L2$ was significantly decreased. In the latter case, i.e., when the value of d was $1.30 \times 10^{-2}$, the Curie temperature Tc was lower than 300°C, and the rate of change in piezoelectric constant $\Delta D$ was greatly increased. On the other hand, when the value of c/d was 2.5 or 18.75, the actual displacement $\Delta L2$ was greatly decreased.

When a high voltage is applied to a piezoelectric element, piezoelectricity disappears. The electric field value at which piezoelectricity disappears is referred to as "coercive electric field". The coercive electric field is preferable as high as possible because when the coercive electric field is high, piezoelectricity does not disappear even by applying a high voltage to a piezoelectric element due to some cause. In the piezoelectric element of each of the examples, the value of coercive electric field was about 10 kV/cm and thus satisfactory.

The present invention claims priority on the basis of Japanese Patent Application No. 2005-056222 filed on March 1, 2005, and all contents thereof are cited in the specification.

Industrial Applicability

A piezoelectric element of the present invention can be used in a wide field including an oscillator circuit and a filter circuit in an analogue electronic circuit as well as an actuator and a sensor.

**Claims**

1.   A piezoelectric element comprising an electrode disposed on at least one of the front and back surfaces of a piezoelectric material prepared by molding a mixture containing a Pb component, a Zr component, a Ti component, a Sr component, a Nb component, and a Zn component and then firing the molded product,
     wherein the piezoelectric material is represented by the general formula $Pb(Zr_aTi_{1-a})O_3 + bSrO + cNbO_{2.5} + dZnO$, the relative amounts of the respective components satisfying the following relations:

$$0.51 \leq a \leq 0.54;$$

$$1.1 \times 10^{-2} \leq b \leq 6.0 \times 10^{-2};$$

$$0.9 \times 10^{-2} \leq c \leq 4.25 \times 10^{-2};$$

$$0.1 \times 10^{-2} \leq d \leq 1.25 \times 10^{-2};$$

and

$$2.9 \leq c/d \leq 15.0.$$

2.   The piezoelectric element according to claim 1, wherein the piezoelectric constant $d_{33}$ determined from a relation between voltage and displacement measured by applying a DC electric field from 0 V to 1000 V using an electric micrometer at room temperature is 900 pm/V or more, and the Curie temperature Tc is 300°C or higher.

3.   The piezoelectric element according to claim 1 or 2, wherein the displacement measured by applying a DC electric field from 0 V to 200 V using an electric micrometer at room temperature is 0.18 $\mu$m or more, and the Curie temperature Tc is 300°C or higher.

4. A piezoelectric element comprising an electrode disposed on at least one of the front and back surfaces of a piezoelectric material containing lead zirconate titanate as a base and a Zn component, wherein the piezoelectric constant $d_{33}$ determined from a relation between voltage and displacement measured by applying a DC electric field from 0 V to 1000 V using an electric micrometer at room temperature is 900 pm/V or more, and the Curie temperature Tc is 300°C or higher.

5. The piezoelectric element according to claim 4, wherein the piezoelectric material contains a Pb component, a Zr component, a Ti component, a Sr component, a Nb component, and a Zn component.

6. A piezoelectric element comprising an electrode disposed on at least one of the front and back surfaces of a piezoelectric material containing lead zirconate titanate as a base and a Zn component, wherein the displacement measured by applying a DC electric field from 0 V to 200 V using an electric micrometer at room temperature is 0.18 $\mu$m or more, and the Curie temperature Tc is 300°C or higher.

7. The piezoelectric element according to claim 6, wherein the piezoelectric material contains a Pb component, a Zr component, a Ti component, a Sr component, a Nb component, and a Zn component.

8. The piezoelectric element according to claim 2, 4, or 5, wherein the piezoelectric constant $d_{33}$ is 1000 pm/V or more.

9. The piezoelectric element according to claim 3, 5, or 7, wherein the displacement at 200 V is 0.20 $\mu$m or more.

FIG.1

# FIG.2

(a)

(b)

# FIG.3

Piezoelectric element

$\bigominus$

ΔL1

L

↑P

V

Piezoelectric material

Electrode

$\bigoplus$

P : Polarization direction

| | |
|---|---|
| **INTERNATIONAL SEARCH REPORT** | International application No.<br>PCT/JP2006/303416 |

A. CLASSIFICATION OF SUBJECT MATTER
*H01L41/09*(2006.01), *C04B35/49*(2006.01), *H01L41/187*(2006.01),
*H01L41/22*(2006.01), *H01L41/24*(2006.01)

According to International Patent Classification (IPC) or to both national classification and IPC

B. FIELDS SEARCHED

Minimum documentation searched (classification system followed by classification symbols)
*H01L41/09*(2006.01), *C04B35/49*(2006.01), *H01L41/187*(2006.01),
*H01L41/22*(2006.01), *H01L41/24*(2006.01)

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-68754 A  (Kyocera Corp.),<br>16 March, 2001 (16.03.01),<br>Par. Nos. [0021] to [0022]<br>(Family: none) | 1-9 |
| A | JP 2000-7431 A  (TDK Corp.),<br>11 January, 2000 (11.01.00),<br>Par. Nos. [0013] to [0014]<br>& US 6207069 B1          & CN 1227200 A<br>& TW 561137 B | 1-9 |

☐ Further documents are listed in the continuation of Box C.     ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>   08 May, 2006 (08.05.06) | Date of mailing of the international search report<br>   23 May, 2006 (23.05.06) |
|---|---|
| Name and mailing address of the ISA/<br>   Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001515835 W

- JP 2005056222 A